# EUROPÄISCHE PATENTSCHRIFT

(11) **EP 0 724 774 B1**
(45) Veröffentlichungstag und Bekanntmachung des Hinweises auf die Patenterteilung: **24.02.1999**
(21) Anmeldenummer: 94929407.8
(22) Anmeldetag: 20.10.1994
(51) Int. Cl.: H01L 21/00

(54) **GREIFER FÜR SCHEIBENFÖRMIGE GEGENSTÄNDE**
GRIPPERS FOR DISC-SHAPED ARTICLES
DISPOSITIF DE PREHENSION POUR OBJETS EN FORME DE DISQUE

(30) Priorität: 22.10.1993 AT 2144/93
(43) Veröffentlichungstag der Anmeldung: 07.08.1996
(73) Patentinhaber: SEZ Semiconductor-Equipment Zubehör für die Halbleiterfertigung AG, 9500 Villach (AT)
(72) Erfinder: SUMNITSCH, Franz, A-9020 Klagenfurt (AT)
(74) Vertreter: Beer, Manfred, Dipl.-Ing.
(86) Internationale Anmeldenummer: AT9400153
(87) Internationale Veröffentlichungsnummer: WO9511518

(56) Entgegenhaltungen:
- EP-A- 0 396 951
- DE-U- 9 204 457
- US-A- 4 453 757
- IBM TECHNICAL DISCLOSURE BULLETIN., Bd.27, Nr.7B, Dezember 1984, NEW YORK US Seite 4472 NICHOLLS 'CENTERING MECHANISM FOR ROBOT DISK HOLDER'

## Beschreibung

Die Erfindung betrifft einen Greifer für scheibenförmige Gegenstände mit den Merkmalen des einleitenden Teils von Anspruch 1. Ein derartiger Greifer ist aus der US-A-4 453 757 bekannt.

In der Praxis stellt sich häufig das Problem scheibenförmige Gegenstände so zu erfassen, daß weder die Oberseite noch die Unterseite des scheibenförmigen Gegenstandes berührt wird, daß also der scheibenförmige Gegenstand lediglich an seinem Außenumfang (Außenrand) erfaßt und gehalten wird. Dieses Problem stellt sich beispielsweise bei der Handhabung von Siliziumscheiben (Wafers), deren Flächen nicht berührt werden dürfen, wenn der Wafer von einem Greifer gehalten wird.

Bei dem aus der DE-A-3 915 038 bekannten Greifer sind am Rand eines scheibenförmigen Gegenstandes angreifende Haltearme vorgesehen, die mit Hilfe von Druckmittelmotoren entlang zueinander in einem Winkel stehender Bewegungsbahnen verstellbar sind. Dabei sollen die Haltearme von den Kolben-Zylinder-Einheiten aufeinander zu bzw. voneinander weg bewegt werden. Bei den Kolben-Zylinder-Einheiten sind an den Zylindern angreifende Schraubendruckfedern vorgesehen, welche die Zylinder in ihre Ausgangslage (einander angenäherte Stellung der Greiffinger) zurückdrücken sollen.

Bei der US-A 4 453 757 ist die Spreizeinrichtung ein im Grundkörper verdrehbarer zylinderförmiger Bauteil, der beim Verdrehen aufgrund von in seinem Außenumfang vorgesehenen Nuten, die mit im Grundkörper angeordneten Führungsrollen zusammenwirken, relativ zum Grundkörper angehoben und gesenkt wird. Zum Betätigen der Greifklauen sind im Ausenumfang des zylinderförmigen Bauteils weitere Nuten vorgesehen, die eine sich ändernde Tiefe aufweisen, so daß beim Verdrehen des zylindrischen Bauteils gegenüber dem Grundkörper die Greifklauen radial zum Grundkörper verstellt werden können.

Diese Kombination von zwei zueinander senkrecht ausgerichteten Bewegungen (Radialverstellung und Heben und Senken) ist für die Greifer der US-A-4 453 757 von wesentlicher Bedeutung, da so vermieden werden soll, daß die Greifklauen an der Unterseite des Wafer reiben, wenn dieser ergriffen wird.

Aus dem DE-U-92 04 457.3 ist eine Vorrichtung zum Aufweiten von elastischen Ringen bekannt. Bei dieser Vorrichtung sind Halterungen für Spreizfinger vorgesehen, die durch eine konische Spreizeinrichtung entgegen der Kraft von Federn radial nach außen verstellbar sind, um den elastischen Ring aufzuweiten. Um den so aufgeweiteten, elastischen Ring auf einem weiteren Bauteil aufzusetzen, sind zusätzliche Finger vorgesehen, welche den Ring von den Spreizfingern abstreifen.

Aus IBM Technical Disclosure Bulletin Vol. 27, Nr. 7B (Dezember 1984) ist eine Halterung für scheibenförmige Gegenstände bekannt, die drei Greifelemente aufweist. Jedes Greifelement trägt eine genutete Rolle, wobei der scheibenförmige Gegenstand, wenn er von der Halterung gehalten wird, mit seinem Rand in die Nuten der Rollen eingreift.

Einen Manipulator mit verschwenkbaren Greifklauen zeigt die US-A-4 227 851. Bei diesem aus der US-A- 4 227 851 bekannten Manipulator werden die Greifklauen, die an einem rohrförmigen Träger verschwenkbar gelagert sind, durch eine Zugfeder belastet. Zum Betätigen der Greifklauen ist im Inneren des rohrförmigen Körpers ein fliegender Kolben vorgesehen, der beim Beaufschlagen mit Druckmedium an Schrägflächen der Greifer angreift, um diese zu spreizen.

Der Erfindung liegt die Aufgabe zurgrunde, einen Greifer der eingangs genannten Gattung anzugeben, in dem die oben geschilderten Probleme gelöst sind und deren einfachen und funktionssicheren Aufbau aufweist.

Gelöst wird diese Aufgabe gemäß der Erfindung mit einem Greifer, der durch die Merkmale des kennzeichnenden Teil des Anspruchs 1 gekennzeichnet ist.

Bei dem erfindungsgemäßen Greifer können die Greifklauen durch Betätigen der Spreizeinrichtung nach außen bewegt werden, so daß die Greifklauen in einer Bereitschaftsstellung neben dem Außenumfang des zu erfassenden, scheibenförmigen Gegenstandes angeordnet sind. Hierauf wird die Wirkung der Spreizeinrichtung aufgehoben, so daß sich die Greifklauen radial nach innen bewegen und in Anlage an den Außenumfang des scheibenförmigen Gegenstandes gelangen, da sie von den Federmitteln radial nach innen bewegt werden. Wenn es sich bei dem scheibenförmigen Gegenstand um einen solchen mit nicht genau kreisrundem Außenumfang handelt, wie dies beispielsweise bei den erwähnten Wafers der Fall ist, dann legen sich beim weiteren Aufheben der Wirkung der Spreizeinrichtung die noch nicht am Außenrand anliegenden Greifklauen unter der Wirkung der Federmittel ebenfalls an den Außenumfang des Wafers an, so daß dieser ringsherum sicher gehalten wird.

Wenn die Greifklauen an Halterungen befestigt sind, die über Führungsstäbe in Führungsbuchsen, die im Grundkörper eingesetzt sind, verschiebbar geführt sind, ergibt sich eine exakte Führung der Klauen. Die Bestandteile des Greifers und seines Grundkörpers können im Hinblick auf die von ihnen zu erfüllenden Funktionen optimiert werden.

Eine einfache und für das gleichzeitige Spreizen der Greifklauen (Bewegen derselben bezüglich des Grundkörpers radial nach außen) Konstruktion ergibt sich, weil die Spreizeinrichtung einen im Grundkörper senkrecht zur Bewegungsrichtung der Greifklauen verschiebbaren, konischen Spreizkörper aufweist, der mit den radial inneren Enden der Führungsstäbe oder den Führungskörpern zusammenwirkt.

Bevorzugt ist es bei der Erfindung, wenn die außerhalb des Grundkörpers angeordneten Teile der Führungsstäbe in schützenden Faltenbälge aufgenommen sind.

In einer bevorzugten Ausführungsform ist vorgesehen, daß die Greifklauen Stifte aufweisen, die an ihren freien Enden einen radial vorspringenden Flansch haben und daß der Flansch eine von außen nach innen schräg ansteigende obere Begrenzungsfläche hat. Der radial vorspringende Flansch mit seiner keilförmigen Querschnittsform bewirkt, daß sich die Klauen mit ihrem Flansch unter den Außenumfang des Gegenstandes schieben und so auch einen flach auf einer Unterlage liegenden scheibenförmigen Gegenstand erfassen können.

Ein sicherer Halt des scheibenförmigen Gegenstandes am erfindungsgemäßen Greifer ergibt sich, wenn oberhalb des Flansches am Stift ein vorspringender Ring vorgesehen ist. Bevorzugt ist dabei, daß der Ring durch zwei Konusflächen begrenzt ist. Bei dieser Ausführungsform wird der Gegenstand auch dann senkrecht zu seiner Ebene zuverlässig festgehalten, wenn die Kraft der Federmittel nicht so groß ist. Die Gefahr, daß der Gegenstand (Wafer) unter der Wirkung der Greifklauen beschädigt wird, ist damit ausgeschlossen.

Um die Reibungskräfte des erfindungsgemäßen Greifers auf ein Minimum zu reduzieren, kann vorgesehen sein, daß die konische Mantelfläche des Spreizkörpers an Rollen, die frei drehbar an den radial inneren Enden der Führungsstäbe oder den Führungskörpern gelagert sind, anliegt.

Die maximale Spreizstellung entsprechend der Auslegung des erfindungsgemäßen Greifers kann in einfacher Weise so definiert werden, daß die den maximal nach außen verstellten Greifklauen entsprechende End-stellung des Spreizkörpers durch Anlage seines vorderen, verjüngten Endes am Grundkörper bestimmt ist.

Zur Betätigung des Spreizkörpers der Spreizeinrichtung können verschiedene Antriebsmotoren, wie auch Stellmagnete u.dgl. vorgesehen sein. In einer bevorzugten Ausführungsform der Erfindung ist aber vorgesehen, daß der Spreizkörper durch einen im Grundkörper integrierten Druckmittelmotor betätigt wird. Der Druckmittelmotor ist vorzugsweise ein Pneumatikzylinder.

Die Erfindung erstreckt sich auch darauf, daß der Spreizkörper durch einen im Grundkörper integrierten Druckmittelmotor betätigt wird.

Eine Ausführungsform der Erfindung zeichnet sich dadurch aus, daß an den an den Halterungen der Greifklauen nach innen weisende, zungenartige Vorsprünge, die im Abstand über den Flanschen an den Stiften der Greifklauen vorgesehen sind, angeordnet sind.

Die zungenartigen Vorsprünge dienen als Auflage für den von den Klauen gehaltenen, scheibenförmigen Gegenstand, wenn der erfindungsgemäße Greifer so ausgerichtet ist, daß die Klauen vom Grundkörper nach oben weisen.

Weitere Einzelheiten und Merkmale der Erfindung ergeben sich aus der nachstehenden Beschreibung eines Ausführungsbeispieles der Erfindung, in der auf die angeschlossene Zeichnung Bezug genommen wird. Es zeigt
Fig. 1 einen Greifer im Achsialschnitt, wobei auf der linken Hälfte von Fig. 1 die Klauen radial nach innen verschoben sind, wogegen die in Fig. 1 rechts gezeigte Klaue von der Spreizeinrichtung radial nach außen verschoben ist,
Fig. 2 eine Draufsicht auf den erfindungsgemäßen Greifer mit abgenommenem Oberteil,
Fig. 3 ein Detail der Greifklaue in einer abgeänderten Ausführungsform,
Fig. 4 und 5 eine praktische Ausführungsform eines erfindungsgemäßen Greifers.

Der erfindungsgemäße, in der Zeichnung gezeigte Greifer besteht aus einem Grundkörper 1, der im gezeigten Ausführungsbeispiel eine kreisrunde Umrißform hat, und aus, im gezeigten Ausführungsbeispiel sechs, relativ zum Grundkörper 1 radial nach innen und nach außen verschiebbaren Greifklauen 2.

Der Grundkörper 1 besteht aus einer im wesentlichen zylinderförmigen Umfangswand 3, einem Deckelteil 4 und einer Basisplatte 5. Die genannten Bauteile des Grundkörpers 1 sind durch Schrauben 6 miteinander verbunden. Die Basisplatte 5 kann mit der Umfangswand 3 auch einstückig ausgeführt sein.

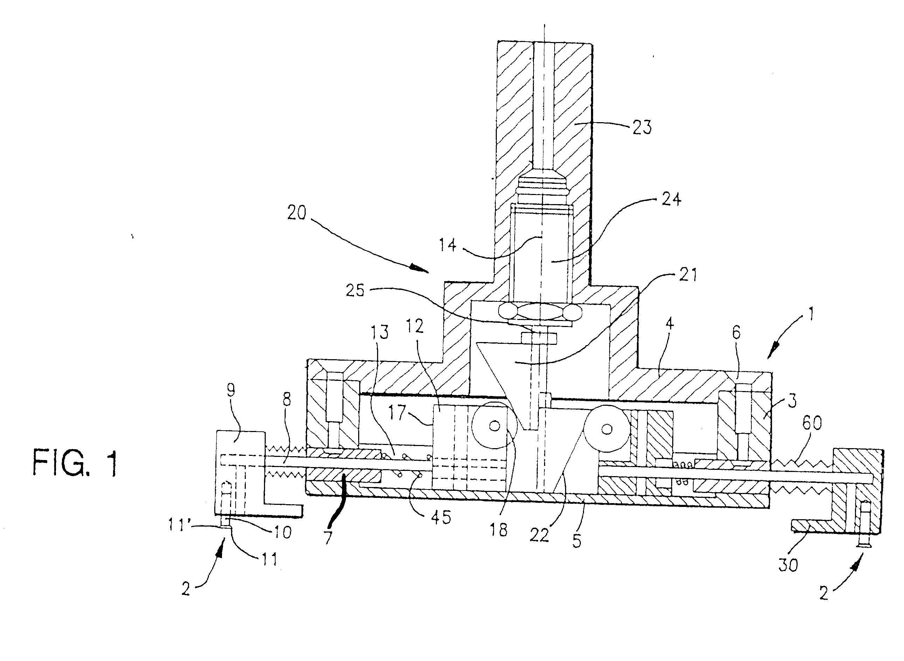

In der Wand 3 des Grundkörpers 1 sind Führungsbuchsen 7 eingesetzt, im welchen radial ausgerichtete Führungsstäbe 8 verschiebbar geführt sind. An den äußeren Enden der Führungsstäbe 8 sind Haltestücke 9 vorgesehen, an welchen Stifte 10 mit jeweils einem radial vorspringenden Flansch 11 (Bund) vorgesehen sind. Die Stifte 10 sind die zum Ergreifen eines scheibenförmigen Gegenstandes wirksamen Teile der Greifklauen 2. Die außerhalb der Wand 3 liegenden Teile der Führungsklaue 8 können wie in Fig. 1 angedeutet durch längenveränderliche Faltenbälge 60 abgedeckt sein.

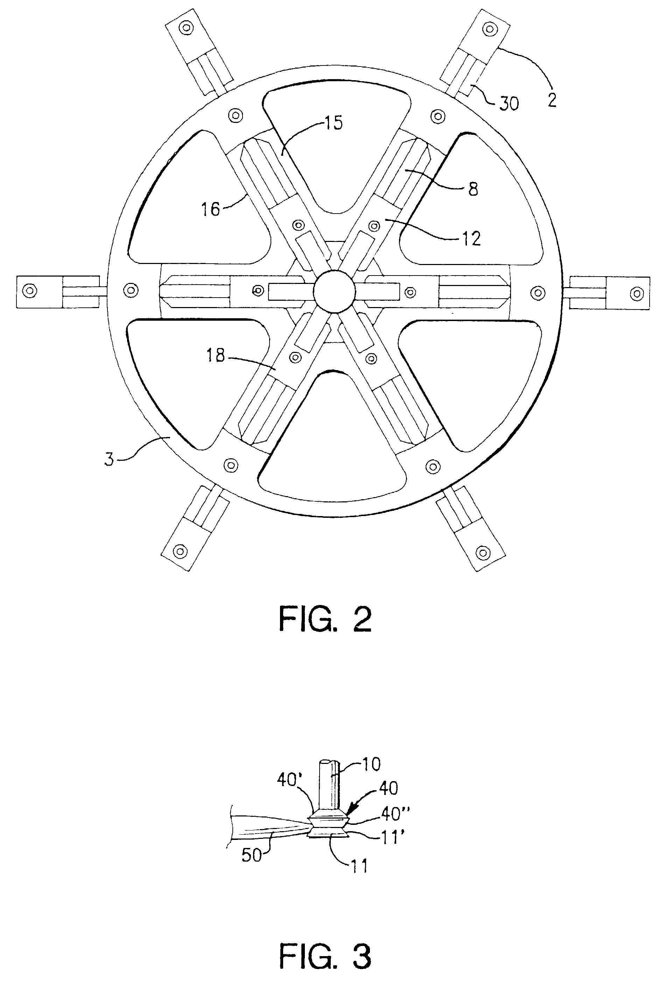

Die Stifte 10 können auch die in Fig. 3 gezeigte Ausführung mit einen von zwei Konusflächen 40' und 40" begrenzten Ring 40 oberhalb des Flansches 11 besitzen. Bei dieser Ausführungsform können die noch zu beschreibenden Ansätze 30 an den Haltekörpern 9 auch entfallen.

An den radial inneren Enden der Führungsstäbe 8 sind Führungskörper 12 befestigt, die in Führungsnuten 13 bezüglich der Achse 14 radial verschiebbar sind. Die Führungsnuten 13 für die Führungskörper 12 werden von je zwei annähernd radial verlaufenden Wänden 15, 16 gebildet, die an der beispielsweise mit der seitlichen Wand 3 einstückig ausgebildeten Basisplatte 5 des Grundkörpers 1 nach innen vorstehen, angeformt sind.

Um die Greifklauen 2 aus der in Fig. 1 links gezeigten Bereitschaftsstellung, in die sie durch Federn (z.B. über die Führungsstifte 8 gesetzte Schraubendruckfedern 45 oder eine ringförmige Schraubenfeder oder ein gummielastisches Band, das um die Außenflächen 17 der Führungskörper 12 gelegt ist) verschoben werden, radial nach außen zu drücken, ist eine Spreizeinrichtung 20 vorgesehen.

Die Spreizeinrichtung 20 besteht im gezeigten Ausführungsbeispiel aus einem Spreizkörper 21 mit konischer Mantelfläche 22, der über an den Führungskörpern 12 frei drehbar gelagerte Rollen 18 auf die Führungskörper 12 und damit auf die Greifklauen 2 einwirkt. Zum Betätigen des Spreizkörpers 21 ist in einem schaftartigen Ansatz des Deckelteils 4 des Grundkörpers 1 ein Druckmittelmotor 24, vorzugsweise ein Pneumatikzylinder, aufgenommen, dessen Kolbenstange 25 mit dem Spreizkörper 21 verbunden ist.

An den Haltekörpern 9 für die Stifte 10 sind radial nach innen weisende, zungenartige Ansätze 30 vorgesehen. Diese Ansätze 30 dienen dazu, als Auflage für einen scheibenförmigen Gegenstand zu dienen, wenn die Basisplatte 5 des Grundkörpers 1 durch Verdrehen des Grundkörpers 1 nach oben weist.

Wenn mit dem erfindungsgemäßen Greifer ein auf einer horizontalen Fläche liegender, flacher Gegenstand 50, z.B. ein Silizium-Wafer aufgenommen (ergriffen) werden soll, wird zunächst der Pneumatikzylinder 24 betätigt, um den Spreizkörper 21 nach unten bis in Anlage an die Innenseite der Basisplatte 5 zu drücken, worauf sich die Greifklauen 2 in ihrer radial äußersten Stellung befinden. Nun wird der Greifer von Hand aus oder über einen Bewegungsautomaten (Roboter) in eine Stellung bewegt, in der sich die Stifte 10 der Greifklauen 2 neben den Außenumfang des zu erfassenden Gegenstandes befinden. Sobald dies geschehen ist, wird der Spreizkörper 21 nach oben bewegt, so daß die Stifte 10 unter der Wirkung des mindestens einen elastischen Mittels in Anlage an den Außenumfang des scheibenförmigen Gegenstandes 50 gelangen. Das Ergreifen erfolgt auch dann zuverlässig, wenn der Gegenstand 50 auf einer Unterlage flächig aufliegt, da die Flansche 11 an den freien Enden der Greifstifte 10 schräg nach oben weisende (konusmantelförmige), obere Begrenzungsflächen 11' aufweisen, so daß der scheibenförmige Gegenstand beim nach innen Bewegen der Stifte 10 etwas angehoben wird, da er über die Schrägfläche 11' bis nach oben gleitet, bis die Stifte 10 am Außenumfang des Gegenstandes anliegen.

Wenn es sich bei dem scheibenförmigen Gegenstand, wie dies bei Silizium-Wafers der Fall ist, um einen nicht exakt kreisrunden Gegenstand handelt, dann werden einige der Greifklauen 2 nicht gleich am Außenumfang des Gegenstandes anliegen. Wird aber der Spreizkörper 21 weiter angehoben, dann bewegen sich auch die noch nicht anliegenden Greifklauen 2 unter der Wirkung des wenigstens einen ihnen zugeordneten Federmittels radial nach innen, bis sie ebenfalls am Außenumfang des Gegenstandes anliegen. Durch dieses schrittweise Anlegen der Greifklauen 2 wird ein genau zentriertes Halten des scheibenförmigen Gegenstandes gewährleistet.

Zusammenfassend kann der Greifer beispielsweise wie folgt dargestellt werden:

Um scheibenförmige Gegenstände (Silizium-Wafers) zu erfassen, weist der Greifer relativ zu einem Grundkörper radial nach innen und nach außen verschiebbar geführte Greifklauen 2 auf. Die Greifklauen 2 werdem durch Federmittel radial nach innen zu belastet. Im Grundkörper 1 ist eine Spreizeinrichtung 20 mit einem konischen Spreizkörper 21 vorgesehen, durch welche alle Greifklauen 2 gemeinsam entgegen der Wirkung der Federmittel radial nach außen bewegt werden können. Durch Zurückbewegen der Spreizeinrichtung 20 legt sich wenigstens ein Teil der Greifklauen 2 an den Außenumfang des scheibenförmigen Gegenstandes an. Beim weiteren Zurückbewegen der Spreizeinrichtung 20 legen sich auch die restlichen Klauen unter der Wirkung der ihnen zugeordneten Federmittel den Außenumfang des scheibenförmigen Gegenstandes an. Der Spreizkörper 21 der Spreizeinrichtung 20 wirkt über im Inneren des Grundkörpers vorgesehene Führungskörper 12, die mit den Greifklauen 2 über Führungsstäbe 8 verbunden sind, auf die Greifklauen 2 ein.

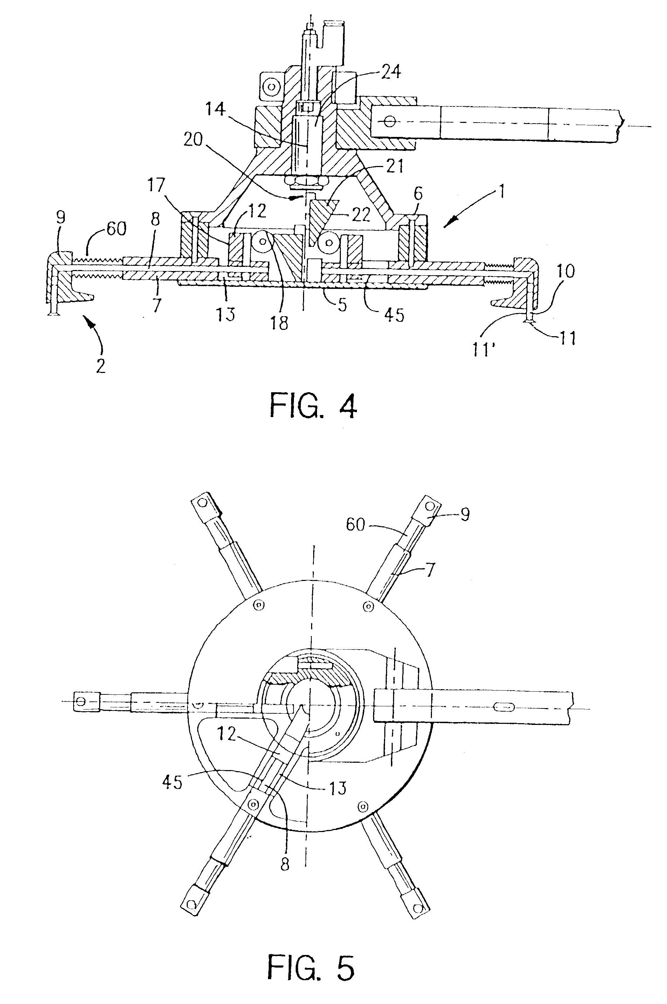

Eine praktische Ausführungsform ist in den Fig. 4 und 5 in zwei Ansichten gezeigt.

## Patentansprüche

1. Greifer für scheibenförmige Gegenstände mit wenigstens annähernd kreisrundem Außenumfang, mit einem Grundkörper (1) mit relativ zum Grundkörper (1) radial nach innen und nach außen verschiebbar geführten Greifklauen (2), die zur Anlage an den Außenumfang des scheibenförmigen Gegenstandes bestimmt sind, wobei die Greifklauen (2) an Führungsstäben (8) angebracht sind, wobei an den Führungsstäben (8) in Führungsnuten (13), die im Grundkörper (1) vorgesehen sind, geführte Führungskörper (12) befestigt sind und wobei über die Führungsstäbe (8) gesteckte Schraubendruckfedern vorgesehen sind, die mit einem Ende an den nach außen weisenden Flächen (17) der Führungskörper (12) anliegen und mit ihrem anderen Ende am Grundkörper (1) abgestützt sind, und welche die Greifklauen (2) im Sinne einer Verstellung radial nach innen belasten, und mit einer Spreizeinrichtung (20), um die Greifklauen entgegen der Wirkung der Schraubendruckfedern nach außen zu verschieben, dadurch gekennzeichnet, daß die Spreizeinrichtung (20) einen im Grundkörper (1) senkrecht zur Bewegungsrichtung der Greifklauen (2) verschiebbaren konischen Spreizkörper (21) aufweist, dessen Konusfläche (22) den an den inneren Enden der Führungsstäbe (8) der Greifklauen (2) angeordneten Führungskörpern (12) zugeordnet ist.

2. Greifer nach Anspruch 1, dadurch gekennzeichnet, daß die außerhalb des Grundkörpers (1) angeordneten Teile der Führungsstäbe (8) in schützenden Faltenbälgen (60) aufgenommen sind.

3. Greifer nach Anspruch 1 oder 2, dadurch gekennzeichnet, daß die Greifklauen (2) Stifte (10) aufweisen, die an ihren freien Enden einen radial vorspringenden Flansch (11) haben und daß der Flansch (11) eine von außen nach innen schräg ansteigende, obere Begrenzungsfläche (11') hat.

4. Greifer nach Anspruch 3, dadurch gekennzeichnet, daß oberhalb des Flansches (11) am Stift (10) ein vorspringender Ring (40) vorgesehen ist.

5. Greifer nach Anspruch 4, dadurch gekennzeichnet, daß der Ring (40) durch zwei Konusflächen (40', 40") begrenzt ist.

6. Greifer nach einem der Ansprüche 1 bis 5, dadurch gekennzeichnet, daß die konische Mantelfläche (22) des Spreizkörpers (21) an Rollen (18), die an den Führungskörpern (12) frei drehbar gelagert sind, anliegt.

7. Greifer nach einem der Ansprüche 1 bis 8, dadurch gekennzeichnet, daß die den maximal nach außen verstellten Greifklauen (2) entsprechende Endstellung des Spreizkörpers (21) durch Anlage seines vorderen, verjüngten Endes am Grundkörper (1, 5) bestimmt ist.

8. Greifer nach einem der Ansprüche 1 bis 7, dadurch gekennzeichnet, daß der Spreizkörper (21) durch einen in den Grundkörper (1) integrierten Druckmittelmotor (24) betätigt wird.

9. Greifer nach einem der Ansprüche 3 bis 8, dadurch gekennzeichnet, daß an den an den Halterungen (9) der Greifklauen (2) nach innen weisende, zungenartige Vorsprünge (30), die im Abstand über den Flanschen (11) an den Stiften (10) der Greifklauen (2) vorgesehen sind, angeordnet sind.

## Claims

1. A gripper for disc-shaped articles with an at least approximately circular periphery, with a base body (1) with gripper claws (2) guided to shift radially inwards and outwards and which are adapted to bear on the outer periphery of the disc-shaped article, wherein the gripper claws (2) are fitted on guide rods (8), wherein guide bodies (12) are fixed on the guide rods (8) and are guided in guide grooves (13) which are provided in the base body (1) and wherein helical compression springs are fitted over the guide rods (8), bearing at one end on the outwardly facing surfaces (17) of the guide bodies (12) and supported at the other end by the base body (1), which springs bias the gripper claws (2) in the sense of radially inward movement, and with a spreader device (20) for shifting the gripper claws outwardly against the action of the helical compression springs, characterized in that the spreader device (20) comprises a conical spreader body (21) movable perpendicular to the direction of movement of the gripper claws (2), with its cone surface (22) associated with the guide bodies (12) arranged on the inner ends of the guide rods (8) of the gripper claws (2).

2. A gripper according to claim 1, characterized in that the parts of the guide rods (8) disposed outside the base body (1) are received in protective bellows (60).

3. A gripper according to claim 1 or 2, characterized in that the gripper claws (2) comprise pins (10) which have a radially projecting flange (11) at their free ends, and in that the flange (11) has an upper bounding surface (11') rising obliquely from the outside to the inside.

4. A gripper according to claim 3, characterized in that the a projecting ring (40) is provided on the pin (10) above the flange (11).

5. A gripper according to claim 4, characterized in that the ring (40) is bounded by two conical surfaccs (40', 40").

6. A gripper according to any of claims 1 to 5, characterized in that the conical peripheral surface (22) of the spreader body (21) bears on rollers (18) which are freely rotatably mountcd on the guide bodies (12).

7. A gripper according to any of claims 1 to 6, characterized in that the end position of the spreader body (21) corresponding to the maximum outwardly shifted position of the gripper claws (2) is determined by abutment of its leading, tapered end on the base body (1, 5).

8. A gripper according to any of claims 1 to 7, characterized in that the spreader body (21) is actuated by a pressure medium motor (24) integrated in the base body (1).

9. A gripper according to any of claims 3 to 8, characterized in that inwardly pointing tongue-like projections (30) are arranged on the holders (9) of the gripper claws (2), spaced above the flanges (11) on the pins (10) of the gripper claws (2).

## Revendications

1. Dispositif de préhension pour des objets en forme de disques à contour extérieur au moins sensiblement circulaire, comportant un corps de base (1) avec des griffes de préhension (2) guidées avec possibilité de coulissement radialement vers l'intérieur et vers l'extérieur par rapport au corps de base (1), qui sont destinées à venir en appui sur le contour extérieur de l'objet en forme de disque, les griffes de préhension (2) étant montées sur des tiges de guidage (8), des éléments de guidage (12) qui sont guidés dans des rainures de guidage (13) prévues dans le corps de base (1) étant fixés aux tiges de guidage (8) et des ressorts hélicoïdaux de compression étant enfilés sur les tiges de guidage (8), lesquels ressorts prennent appui par une extrémité sur les faces (17) tournées vers l'extérieur des éléments de guidage (12) et par leur autre extrémité sur le corps de base (1) et sollicitent les griffes de préhension (2) dans le sens d'un déplacement radial en direction de l'intérieur, ainsi qu'un dispositif d'ouverture (20) pour déplacer les griffes de préhension en direction de l'extérieur, à l'encontre de l'action des ressorts hélicoïdaux de compression, caractérisée par le fait que le dispositif d'ouverture (20) comporte un élément d'ouverture (21) conique qui coulisse dans le corps de base (1) perpendiculairement à la direction de déplacement des griffes de préhension (2), dont la surface conique (22) est associée aux éléments de guidage (12) disposés aux extrémités intérieures des tiges de guidage (8) des griffes de préhension (2).

2. Pince selon la revendication 1, caractérisée par le fait que les parties des tiges de guidage (8) disposées à l'extérieur du corps de base (1) sont logées dans des soufflets de protection (60).

3. Pince selon la revendication 1 ou 2, caractérisée par le fait que les griffes de préhension (2) comportent des broches (10) qui sont pourvues à leur extrémité libre d'une joue formant saillie radiale (11) et par le fait que la joue (11) présente une face (11') supérieure inclinée qui s'élève de l'extérieur vers l'intérieur.

4. Pince selon la revendication 3, caractérisée par le fait qu'il est prévu sur la broche (10), au-dessus de la joue (11), une bague (40) saillante.

5. Pince selon la revendication 4, caractérisée par le fait que la bague (40) est délimitée par deux surfaces coniques (40', 40").

6. Pince selon une des revendications 1 à 5, caractérisée par le fait que la surface extérieure conique (22) de l'élément d'ouverture est en contact avec des galets (18) qui sont montés libres en rotation sur les éléments de guidage (12).

7. Pince selon une des revendications 1 à 6, caractérisée par le fait que la position extrême de l'élément d'ouverture (21) correspondant au déplacement maximal vers l'extérieur des griffes de préhension (2) est déterminée par l'entrée en contact de l'extrémité antérieure rétrécie de celui-ci avec le corps de base (1, 5).

8. Pince selon une des revendications 1 à 7, caractérisée par le fait que l'élément d'ouverture (21) est actionné par un moteur à fluide sous pression (24) intégré dans le corps de base (1).

9. Pince selon une des revendications 3 à 8, caractérisée par le fait que des saillies (30) en forme de pattes orientées vers l'intérieur disposées à distance au-dessus des joues (11) des broches (10) des griffes de préhension (2), sont prévues sur les fixations (9) des griffes de préhension (2).
